(19) Europäisches Patentamt

European Patent Office

Office européen des brevets

(11) **EP 0 951 500 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(21) Anmeldenummer: **96941054.7**

(22) Anmeldetag: **29.11.1996**

(51) Int Cl.$^7$: **C08J 5/18**

(86) Internationale Anmeldenummer:
**PCT/EP96/05305**

(87) Internationale Veröffentlichungsnummer:
**WO 97/020881 (12.06.1997 Gazette 1997/25)**

(54) **PTFE-KÖRPER AUS MIKROPORÖSEM POLYTETRAFLUORETHYLEN MIT FÜLLSTOFF**

MICROPOROUS POLYTETRAFLUOROETHYLENE (PTFE) BODIES WITH FILLER

CORPS EN POLYTETRAFLUOROETHYLENE (PTFE) MICROPOREUX COMPRENANT UNE CHARGE

(84) Benannte Vertragsstaaten:
**AT BE DE FR IT NL**

(30) Priorität: **01.12.1995 DE 19544912**

(43) Veröffentlichungstag der Anmeldung:
**27.10.1999 Patentblatt 1999/43**

(73) Patentinhaber: **W.L. GORE & ASSOCIATES GmbH**
**85640 Putzbrunn (DE)**

(72) Erfinder:
• **RUDOLF, Christiane**
**D-85435 Erding (DE)**
• **BÜRGER, Wolfgang**
**D-81825 München (DE)**
• **TILLMANNS, Ralf**
**D-91785 Pleinfeld (DE)**

(74) Vertreter: **Klunker . Schmitt-Nilson . Hirsch**
**Winzererstrasse 106**
**80797 München (DE)**

(56) Entgegenhaltungen:
EP-A- 0 402 901    EP-A- 0 437 721
WO-A-90/10673    WO-A-93/07179
US-A- 4 153 661    US-A- 4 187 390
US-A- 4 194 040

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen PTFE-Körper, bestehend aus mikroporösem PTFE, z.B. gerecktem Polytetrafluorethylen (ePTFE) mit einem Füllstoff, und ein Verfahren zum Herstellen eines solchen PTFE-Körpers.

Polytetrafluorethylen (PTFE) ist aufgrund seiner speziellen Eigenschaften für unterschiedliche Zwecke verwendet worden. Für spezielle Verwendungszwecke wird PTFE mit einem Füllstoff versehen, um die Eigenschaften des PTFE für den speziellen Anwendungszweck zu modifizieren. So ist es z. B. aus der US-Patentschrift 4 949 284 (Arthur et al) bekannt, in PTFE-Material einen keramischen Füllstoff (SiO$_2$) und eine geringfügige Menge von Mikroglasfasern einzubringen, wobei die Mikroglasfasern eine Partikelgröße von 10 - 15 µm besitzen. Mit diesem Material werden Platinen für gedruckte Schaltungen (PWB = Printed Wiring Board) hergestellt.

Durch den keramischen Füllstoff wird die Dimensionsstabilität gegenüber PTFE/Glasfaser-Verbundstoffen verbessert. Im allgemeinen sind diese Stoffe nicht porös.

Durch eine spezielle Verarbeitung von PTFE läßt sich ein poröser Werkstoff erhalten. Durch Pastenextrusion von PTFE-Material und Recken des extrudierten Materials bei einer Temperatur von bis zu etwa 330 °C und nachfolgendes Sintern oberhalb des kristallinen Schmelzpunkts des PTFE-Materials wird eine poröse PTFE-Struktur erhalten, in der Knoten durch diese verbindende Fibrillen gehalten werden (Knoten-Fibrillen-Struktur). Dieses durch Recken expandierte PTFE wird mit ePTFE abgekürzt. Das Recken erfolgt z. B. mit einer Rate von 10 %/s. Je nachdem, wie stark das Material gereckt wird, erhält man ein Material mit mehr oder weniger großer Dichte (spezifischem Gewicht).

Dieses ePTFE kann man zu Membranen formen, die für Luft und Wasserdampf durchlässig sind, jedoch für Wasser undurchlässig sind. Man kann das Material zu Schnüren formen, um es gesintert oder ungesintert als Dichtungsmaterial zu verwenden. Man kann das Material laminieren, es auf einer Seite oder auf beiden Seiten mit einer oder mehreren Lagen ausstatten, um Mehrschichtstoffe zu bilden. Aus dem Stand der Technik sind zahlreiche Anwendungen für solches Material bekannt.

Für spezielle Einsatzzwecke ist es bekannt, solches poröses PTFE (ePTFE) mit einem Füllstoff zu füllen, um bestimmte mechanische, physikalische, chemische oder elektrische Eigenschaften zu erzielen. Aus der EP-A-0 463 106 (Mortimer) ist eine Folie und deren Herstellung durch Mischen von PTFE mit einem Füllstoff bekannt. Als Füllstoff werden beispielsweise Aluminiumoxid, Titandioxid, Glasfasern, Ruß, Aktivkohle und dergleichen angegeben. Die Füllstoff-Partikel haben eine Größe, die zwischen etwa 1 und 100 µm liegt. Im allgemeinen liegt der Anteil des Füllstoffs über 25 Vol.-%.

Die EP-A-0 463 106 offenbart eine gefüllte PTFE-Folie mit einer Dicke zwischen 2,5 bis 127 µm, wobei der Füllstoff eine Größe von weniger als 40 µm, bevorzugt 1 - 15 µm besitzt. Im Zuge des Herstellungsprozesses wird die durch Pastenextrusion und/oder Kalandrieren gebildete Folie gedehnt und anschließend verdichtet, um das Material auf die gewünschte Stärke zu komprimieren. Durch das Verdichten wird nicht nur die gewünschte Folienstärke erzielt, während die Porosität verringert wird, das Verdichten dient auch zum Fixieren der Füllstoffe. Naturgemäß kann die Folie nicht dünner sein als der Durchmesser der keramischen Füllstoffpartikel. Soll die Folie 3 µm dick sein, so darf praktisch kein Füllstoffpartikel größer als 3 µm im Durchmesser sein.

Während man z. B. die elektrischen Eigenschaften von expandiertem porösem PTFE (ePTFE) durch Zugabe von Kohlenstoff-/Metallpartikeln beeinflussen kann, leiden die ursprünglichen mechanischen Eigenschaften dieses porösen PTFE in dem Maße, in dem der Anteil des Füllstoffs erhöht wird. Die Füllstoff-Partikel stellen in der oben erläuterten Knoten-Fibrillen-Struktur Defekte dar, die die Eigenschaften des ungefüllten ePTFE verändern. Bei expandiertem PTFE ohne Füllstoff liegt die Porengröße, das ist der mittlere Abstand zwischen den einzelnen Knoten der Struktur, zwischen 0,01 und 10µm. Die relativ großen Füllstoffteilchen (bis zu 100 µm) stellen also ein Vielfaches der Porengröße dar. Insofern fügen sich die Füllstoff-Partikel in expandiertes PTFE in anderer Weise ein als in nicht-poröses PTFE.

Aus der EP-A-0 443 400 (Arthur) ist es bekannt, in nicht-gerecktes (nicht-poröses) PTFE anorganische Partikel einzubringen, um beispielsweise die Dielektrizitätskonstante auf einen niedrigen Wert einzustellen. Die Füllstoff-Partikel können eine Beschichtung aufweisen.

In dem US-Patent 4 153 661 (Ree Buren et al.) ist ein PTFE-Körper offenbart, der mit einem Füllstoff, z. B. Titanoxid, gefüllt ist, wobei als Teilchengröße ein Bereich von 100 Nanometer bis 600 µm, vorzugsweise von 1 µm bis 100 µm angegeben ist. Zunächst werden PTFE und Füllstoff gemischt und weiterverarbeitet, um Fibrillen in dem Material zu erzeugen. Anschließend wird das Material biaxial kalandriert. Ein solches PTFE-Material ist nicht gereckt und kann im Anschluß an die genannten Verarbeitungsschritte auch nicht mehr gereckt werden. Um die Fibrilierung zu erreichen, ist eine relativ große Teilchengröße erwünscht. Als Beispiele sind Bereiche von 20 bis 30 µm und 200 bis 250 µm angegeben. Wird aus diesem Material eine Membran hergestellt, so ist mit einem Füllstoff einer solchen Partikelgröße die Dicke der Membran nach unten auf 20 µm beschränkt. Das US-Patent 4 194 040 offenbart ein Folienmaterial, zu dessen Herstellung als Ausgangsmaterial Partikel mit einem mittleren Partikeldurchmesser von weniger als 10 µm verwendet werden. Das Material enthält als Matrix einen Anteil von 1-15% PTFE zur Fixierung.

Zur Beschichtung von Substraten und dergleichen ist es bekannt, durch Polymerisation von wässrigen Mikroemulsionen ein Latex herzustellen, welches Partikel aus organischem Polymer mit Seitenketten enthält, die eine mittlere Teilchengröße zwischen 0,01 und 0,5 µm besitzen (US-Patente 5 376 441; 5 385 694; 5 460 872; Wu et al). Das Latexmaterial kann dazu dienen, die Wände von porösen Substraten zu bedecken, das Latexmaterial wird nicht in die Struktur eingebunden.

Der Erfindung liegt die Aufgabe zugrunde, einen PTFE-Körper, beispielsweise eine PTFE-Membran anzugeben, der gewünschte zusätzliche Eigenschaften, beispielsweise mechanische Eigenschaften aufweist, und der dennoch die ursprünglichen Struktur-Eigenschaften von ePTFE-Material beibehält.

Zur Lösung dieser Aufgabe schafft die Erfindung gemäß Anspruch 16 einen PTFE-Körper, insbesondere eine PTFE-Membran, bestehend aus mikroporösem, z.B. gerecktem Polytetrafluorethylen (ePTFE) mit einem anorganischem Füllstoff aus Partikeln im Nanometerbereich.

Diese Füllstoff-Partikel haben eine Größe von 5 bis 500 Nanometer (nm), vorzugsweise von 10 bis 300 Nanometer. Sie sollen im folgenden kurz als "Nanopartikel" bezeichnet werden.

Eine Besonderheit von Nanopartikeln ist deren im Vergleich zu ihrem Volumen extrem große Oberfläche. So weist ein Gramm Nanopartikel $Al_2O_3$ (ALCOA®) einer Größe von < 100 nm eine Gesamtoberfläche von 55 - 80 $m^2$ auf.

Die besondere Wirkung von Nanopartikeln in mikroporösem PTFE, insbesondere in expandiertem PTFE, also einem sehr porösem Stoff, ist überraschend; denn einerseits bleibt die Struktur des mikroporösen PTFE trotz des Füllstoffs erhalten, und damit bleiben auch die vorteilhaften Eigenschaften des mikroporösen PTFE erhalten, und andererseits zeigt der aus Nanopartikeln bestehende anorganische Füllstoff die erwünschte Wirkung. Wie weiter unten noch erläutert werden wird, nimmt erfindungsgemäß der Füllstoff an dem Aufbau der Knoten-Fibrillen-Struktur des mikroporösen PTFE teil. Obschon der Füllstoff selbst Bestandteil der Struktur des PTFE-Körpers ist, entfaltet der Füllstoff die gewünschte Wirkung. Dies widerspricht dem, was der Fachmann dem Stand der Technik entnehmen konnte:

So ist in der EP-A-0437 721 (Tamaru et al.) eine halbgesinterte PTFE-Mehrschichtstruktur mit einem Zusatzstoff in zumindest einer der Schichten bekannt. Die Partikelgröße des Zusatzstoffs soll zwischen 0,03 und 20 µm, bevorzugt zwischen 1 und 10 µm liegen. Ausdrücklich gewarnt wird vor einer Unterschreitung einer Mindestgröße: "Wenn er (der Partikeldurchmesser) kleiner als 0,03 µm ist, wird die Wirkung des Zusatzstoffs unzureichend, ist er größer als 20 µm, werden die Formeigenschaften des PTFE-Feinpulvers beeinträchtigt". Die bevorzugte Partikelgröße liegt hier also deutlich über 1000 nm, offenbar deshalb, weil bei kleineren Partikeln keine spürbare Wirkung des Füllstoffs erwartet wird.

Nach der EP-A-0 437 721 soll der Zusatzstoff nicht an der Faserbildung beteiligt sein ("non-fiber-forming material"). Dies steht im Gegensatz zu der Lehre der vorliegenden Erfindung, wonach die Nanopartikel Bestandteil der Struktur sind. Nach dieser Druckschrift konnten Zusatzstoffe mit einer Teilchengröße im Nanometerbereich die beispielsweise mechanischen Eigenschaften des Materials nicht ändern. Überraschenderweise hat sich aber für die Erfinder gezeigt, daß gerade die Verwendung von extrem kleinen Teilchen als Füllstoff für gerecktes PTFE besondere Wirkung zeigt.

Eine Untersuchung des erfindungsgemäßen PTFE-Körpers mit Hilfe eines Rasterelektronenmikroskops hat gezeigt, daß die Nanopartikel nicht die Poren des porösen ePFTE ausfüllen. Stattdessen sind die Nanopartikel Bestandteil der mikroporösen Struktur, so daß sich im mikroskopischen Bild praktisch kein Unterschied zwischen ungefülltem ePTFE und gefülltem ePTFE zeigt.

Hieraus ist erklärlich, daß die ursprüngliche Struktureigenschaft des ungefüllten ePTFE trotz eines beträchtlichen Füllstoff-Anteils praktisch unverändert erhalten bleibt.

Erfindungsgemäß ist ein Bereich von Füllstoff-Partikeldurchmessern 'zwischen 5 und 500 nm vorgesehen. Die Untergrenze von 5 nm ist durch den Umstand bedingt, daß Nanopartikel mit kleineren Durchmessern praktisch nicht zur Verfügung stehen. Die Obergrenze von 500 nm hängt zusammen mit dem Erfordernis, daß die Füllstoff-Partikel nicht die Struktureigenschaft des ungefüllten ePTFE ändern sollen, vielmehr die Füllstoffpartikel Bestandteil der Struktur sein sollen.

Berücksichtigt man die Abmessungen der Fibrillen in einer üblichen ePTFE-Struktur, so würden Füllstoff-Partikeldurchmesser von mehr als 500 nm die Fibrillen-Struktur stören, was der erfindungsgemäßen Lehre zuwiderläuft.

Eine bevorzugte Obergrenze für die Nanopartikel des Füllstoffs beträgt 300 nm. Bei Füllstoffpartikeln mit einem Durchmesser unterhalb von 300 nm ist mit Sicherheit gewährleistet, daß die Partikel die Struktur des mikroporösen PTFE nicht stören, sondern mit Sicherheit Bestandteil der Struktur sind. Am meisten bevorzugt wird eine Obergrenze von 100 nm für die Durchmesser der Füllstoffpartikel. Bei einer solchen Obergrenze von 100 nm ist die Struktur des expandierten PTFE mit Füllstoff praktisch identisch mit der Struktur von expandiertem PTFE ohne Füllstoff. Dennoch werden durch den Füllstoff die gewünschten zusätzlichen Eigenschaften des PTFE-Körpers erreicht.

Mit Hilfe der Nanopartikel lassen sich praktisch sämtliche bekannte Materialien aus ePTFE herstellen. Der Anteil der Nanopartikel in Gew.-% liegt beispielsweise zwischen 5 und 10 Gew.-%, wodurch die gewünschte Wirkung, beispielsweise eine gewünschte Filterwirkung bei ausreichender Materialfestigkeit, erreicht wird. Im Vergleich zu den früher üblichen Füllstoffen ist ein nur geringer Füllstoffanteil ausreichend. Eine Obergrenze für den Anteil an Nanopartikeln ist 50 Gew.-%, bezogen auf die Summe von PTFE und Füllstoff. Oberhalb dieser Obergrenze würden die Eigenschaften des Füllstoffs dominieren. Erwünscht ist aber, die typischen Eigenschaften von gerecktem, porösem PTFE beizubehalten.

Durch geeignete Auswahl der Nanopartikel-Füllstoffe läßt sich z.B. die Abriebfestigkeit von Filtermembranen erhöhen. Bei Filtermembranen besteht das Problem der Reinigung nach längerer Betriebszeit. Will man die Oberfläche der Membran durch Abschaben reinigen, so besteht die Gefahr einer Beschädigung der Membran, insbesondere nach wiederholter Reinigung. Wenn man mit einem geeigneten Zusatzstoff, z.B. $TiO_2$, die Abriebfestigkeit der Membran erhöht, läßt sich die Lebensdauer der Filtermembran beträchtlich steigern.

Der PTFE-Körper mit Füllstoff hat im Vergleich zu einem solchen ohne Füllstoff eine 3-mal, vorzugsweise 5-mal höhere Abriebfestigkeit.

Durch Einbau hydrophiler Nanopartikel in die Struktur von gerecktem PTFE läßt sich eine beträchtliche Durchflußerhöhung erzielen. Dies kommt ebenfalls besonders den zur Filterung eingesetzten Membranen zugute.

Der Begriff "hydrophil" bezieht sich auf die Tendenz eines Stoffs, in Wasser einzudringen und darin zu verbleiben. Setzt man auf die Oberfläche eines Stoffs einen Wassertropfen und vermißt den sich ausbildenden Randwinkel am Wassertropfen, so spricht man bei Randwinkeln von kleiner als 90° von hydrophilen Oberflächen. Die Flüssigkeit, d. h. das Wasser benetzt die Oberfläche (vgl. H.-D. Dörfler "Grenzflächen- und Kolloidchemie" Verlag Carl Hanser 1994). Ursache dieses Phänomens sind insbesondere aktive Hydroxylgruppen an der Oberfläche, außerdem auch Karbonsäuregruppen, Sulfonsäuregruppen, Phosphatgruppen. Die aktiven Hydroxylgruppen entstehen durch die Bildung der Oxide bzw. über die Synthese.

Ein spezielles Beispiel für erfindungsgemäße PTFE-Körper sind mit Keramikmaterial gefüllte Membranen, wie sie für Dialysezellen verwendet werden.

Die Eigenschaften des erfindungsgemäßen PTFE-Körpers mit einem bestimmten Füllstoff in Form von Nanopartikeln sind ähnlich den Eigenschaften herkömmlicher PTFE-Körper mit entsprechenden Füllstoffen. Der Unterschied zu den herkömmlichen PTFE-Körpern besteht jedoch darin, daß der Gewichtsanteil oder Volumenanteil gegenüber den herkömmlichen Füllstoffen beträchtlich reduziert ist. Strukturell gesehen stellen bei dem erfindungsgemäßen PTFE-Körper die Füllstoff-Partikel im Gegensatz zum Stand der Technik keine Defekte der mikroporösen Struktur dar, sondern die Nanopartikel erhalten diese Struktur, z.B. Knoten-Fibrillen-Struktur oder Strickleiter-Struktur praktisch unverändert, da sie selbst Bestandteil dieser Struktur sind.

Als Füllstoff kommen Nanopartikel aus der Gruppe Oxide und Mischoxide in Frage, darunter auch solche Oxide und Mischoxide, deren Oberfläche chemisch modifiziert ist. So kann man z.B. mit Nanopartikeln dieser Art ferromagnetische Eigenschaften erzielen. Stoffe dieser Art lassen sich einsetzen zur Abschirmung von elektrischen Kabeln oder in Leiterplatten.

Unter die oben erwähnte Gruppe "Oxide und Mischoxide" fallen z. B. die verschiedenen Aluminiumhydroxide, die synthetisch hergestellt werden können und auch in der Natur, beispielseise im Bauxit, frei vorkommen in Form des Böhmit, Gibbsit, Alumogel etc. Diese Substanzen enthalten unterschiedliche Mengen an Wasser und Verunreinigungen in Form anderer Metallkationen.

Oxide bzw. Mischoxide sind auch Materialkombinationen für die Herstellung von Oxidkeramik, die auf Basis von z. B. Aluminiumoxid unter Zusatz von BeOMgO, $ZrO_2$ und $MgAl_2O_4$ (Spinell) oder auch Ferriten Titanaten etc. beruhen. Der Zusatz dieser Stoffe verbessert bestimmte Eigenschaften, beispielsweise die Zähigkeit, der Oxidkeramik.

$TiO_2$ und $ZnO$ sind geeignet, die PTFE-Membran undurchlässig für UV-A- und UV-B-Strahlung zu machen. $ZnO$ ist dann günstig als Füllstoff, wenn eine Membran für Bekleidungsstücke antibakterielle und antimikrobielle Eigenschaft erhalten soll.

Bevorzugte Beispiele für keramische Füllstoffe sind $Al_2O_3$, $TiO2$ und $ZrO_2$.

Beispiele für spezielle Eigenschaften von Nanopartikeln finden sich in der EP-A-0 317 945 und der DE-A-41 33 621.

Andere Arten von Füllstoffen sind möglich, z. B. Nanopartikel aus Kohlenstoff (Graphit) oder Metall.

Die Erfindung schafft außerdem ein Verfahren zum Herstellen eines Körpers aus gefülltem, expandiertem PTFE. Das erfindungsgemäße Verfahren weist folgende Schritte auf:

a) Mischen einer Menge PTFE mit einem Füllstoff in Form von Partikeln mit einer Größe im Nanometerbereich;

b) Zugeben eines Gleitmittels zu dem mit Füllstoff gemäß a) gemischten PTFE, und Bilden eines Formkörpers;

c1) Pastenextrusion des Formkörpers; und/oder

c2) Kalandrieren; und

d) Enfernen des Gleitmittels.

Dann folgen vorzugsweise die Schritte:

e) Recken und Sintern des Materials (in eine erste oder x-Richtung) und - vorzugsweise - anschließend

f) Recken des Materials in eine zweite oder y-Richtung, die senkrecht auf der ersten oder x-Richtung steht.

In einer besonders bevorzugten Ausführungsform wird im Schritt a) eine Mischung fester Produkte hergestellt.

Die Herstellung des Materials kann grundsätzlich auf dreierlei verschiedenen Wegen erfolgen, nämlich durch Dispergieren, durch Trockenmischung und durch Ko-Koagulation.

Im folgenden sollen diese drei Verfahren in Verbindung mit der Herstellung einer Filtrations-Membran verbesserter Abriebfestigkeit erläutert werden. Speziell geht es um das Mischen von PTFE und Füllstoff gemäß dem obigen Merkmal a).

Vermischen von Füllstoff und PTFE durch Dispergierung in einem Gleitmittel

Wenn die Nanopartikel des Füllstoffs eine stabile Dispersion in einem zu verwendenden Gleitmittel bilden und nicht zur Aglomeration neigen, erfolgt das Mischen von PTFE und Füllstoff dadurch, daß der Füllstoff in dem Gleitmittel dispergiert wird und die so erhaltene Dispersion einem PTFE-Pulver zugemischt wird. Sind die Oberflächen der Nanopartikel hydrophob, so verwendet man ein bekanntes hydrophobes Gleitmittel. Angaben für geeignete Gleitmittel lassen sich ebenso wie Angaben über PTFE den beiden bereits oben genannten Druckschriften EP-A-4 463 106 und EP-A-0 437 721 entnehmen. Um ein solches hydrophobes Gleitmittel verwenden zu können, kann man die Oberflächen der Nanopartikel mit langkettigen organischen Verbindungen, wie z.B. Karbonsäuren beladen, um sie hydrophob zu machen.

Verwendet man hydrophobe und oleophobe Gleitmittel (z. B. Perfluorpolyether), so macht man die Oberflächen der Nanopartikel beispielsweise dadurch hydrophob und oleophob, daß man sie mit organischen langkettigen Verbindungen belädt, z. B. perfluorierten Karbonsäuren und Perfluorpolyethern mit funktionellen Endgruppen. Bevorzugte Endgruppen sind Phosphate bzw. Phosphorsäureester, Silane, Di- oder Polyole. Spezielle Karbonsäuren sind z. B. Stearinsäure, Laurinsäure etc. (vgl. den Katalogue DEGUSSA, Japan), also langkettige Karbonsäuren geringer Löslichkeit in Wasser sowie polaren organischen Lösungsmitteln mit einer Kettenlänge von 10 Kohlenstoffatomen und mehr. Bevorzugt setzt man als Gleitmittel auf Kohlenwasserstoffbasis gleiche Kettenlängen ein, so daß vom chemischen Standpunkt eine gute Verträglichkeit gegeben ist und die Karbonsäure bei vergleichbaren Temperaturen wie das Gleitmittel entfernt werden kann.

Verwendet man hydrophile Gleitmittel (z.B. Tensidlösungen), so müssen die Oberflächen der Nanopartikel hydrophil sein. Dies ist bei reinen anorganischen Oxiden von Natur aus der Fall, kann aber auch durch Beladung der Nanopartikel mit organischen bifunktionellen Tensiden, Diolen, Dikarbonsäuren und Polyelektrolyten erreicht werden.

Tensidlösungen lassen sich als hydrophile Gleitmittel dann einsetzen, wenn sie die beiden Komponenten PTFE einerseits und Nanopartikel andererseits komplett benetzen. Zu diesem Zweck muß gewährleistet sein, daß eine hinreichende Viskosität der Tensidlösung vorhanden ist, ebenso wie eine ausreichende Oberflächenspannung, die von der Konzentration und der chemischen Struktur der Tenside abhängt. Beispiele für derartige Tensidlösungen sind in der EP-A-0 418 155 (Seite 4, Zeilen 14 bis 17) angegeben.

Das Gleitmittel muß die Oberfläche der PTFE-Aglomerate vollständig benetzen. Dementsprechend muß das Gleitmittel eine bestimmte Oberflächenspannung und Viskosität aufweisen, was den Feststoffanteil in der Dispersion begrenzt. Kompensiert wird dieser Nachteil durch Verwendung sehr kleiner Nanopartikel, die eine entsprechend große spezifische Oberfläche besitzen.

Zunächst wird eine Füllstoff-Dispersion hergestellt, wozu der zur Erhöhung der Abriebfestigkeit verwendete Füllstoff $TiO_2$, der in Pulverform vorliegt, langsam in ein Gleitmittel eingerührt wird. Bei dem Gleitmittel handelt es sich z.B. um Paraffinöl, dem ein geringer Anteil Laurinsäure zugesetzt wurde. Beim Einrühren des $TiO_2$-Pulvers werden die $TiO_2$-Partikel von der Laurinsäure eingehüllt.

Als nächstes wird eine Menge PTFE-Pulver in einen Mischer gegeben, und die $TiO_2$-Dispersion wird langsam zudosiert. Es entsteht ein rieselfähiges Pulver oder Granulat, aus dem in an sich bekannter Weise unter Vakuum ein Formkörper gepreßt wird. Daran schließen sich die obigen Verfahrensschritte c) - f) an.

Vermischen von Füllstoff und PTFE durch Trockenmischung

Die Trockenmischung von PTFE- und Füllstoff-Nanopartikeln wird dann bevorzugt, wenn die Partikelgröße des PTFE-Materials einerseits und des Füllstoffs andererseits identisch ist, keine Aglomeratbildung der Komponenten beobachtet wird und durch die Trockenmischung eine Homogenisierung der Komponenten erreicht wird.

In einem Mischer wird PTFE-Pulver mit pulverförmigem $TiO_2$ mit Nanopartikelgröße gemischt. Diesem Gemisch wird Gleitmittel zudosiert, beispielsweise das oben erwähnte Paraffinöl mit darin gelöster Laurinsäure. Das so erhaltene Granulat wird wiederum zu einem Formkörper verpreßt und in der oben genannten Weise weiterverarbeitet.

Vermischung von Füllstoff und PTFE durch Ko-Koagulation

Eine weitere Möglichkeit, das PTFE-Material mit den Füllstoff-Nanopartikeln zu mischen, ist die Ko-Koagulation. Diese ist dann zu bevorzugen, wenn die Nanopartikel eine stabile wäßrige Dispersion bilden, hydrophile Eigenschaften an der Oberfläche besitzen und nicht zur Aglomeration in dem wäßrigen Medium neigen. Die Koagulation ist dann besonders bevorzugt, wenn die PTFE-Partikel nach der Koagulation eine aus den Nanopartikeln bestehende Hülle aufweisen, oder wenn die Nanopartikel mit einer Hülle aus PTFE-Primärteilchen ausgestattet sein sollen. Die Mechanismen der Ko-Koagulation sind beschrieben in H.-D. Dörfler "Grenzflächen- und Kolloidchemie", Verlag VCH, Weinheim, Deutschland, 1994.

Es wird eine wässrige Dispersion von Nanopartikeln hergestellt, und diese wässrige Dispersion wird mit einer wässrigen Dispersion von PTFE gemischt. Die wässrige Dispersion von PTFE ist im Handel erhältlich.

Verwendet man PTFE-Dispersionen und Nanopartikel-Dispersionen gleicher Teilchengröße, z. B. 200 nm, so erreicht man durch die Ko-Koagulation eine extrem homogene Verteilung der Stoffe.

Verwendet man Nanopartikel mit einer Größe von ca. 20 - 40 nm, wie sie in der erwähnten EP-A-0 418 155 erwähnt sind, und beträgt die Partikelgröße der PTFE-Dispersion 200 nm, so kann man an der Oberfläche des PTFE mehrere Nanopartikel anreichern. Gegebenenfalls verwendet man die Prinzipien der sterischen Koagulation unter Zuhilfenahme von z. B. Polyelektrolyten, um eine bevorzugte Anreicherung an der Oberfläche zu erzielen. Verwendet man dagegen die in der EP-A-0 418 155 erwähnten Nanopartikel mit einer Teilchengröße von ca. 200 nm, während die Partikel der PTFE-Dispersionen eine Teilchengröße von 20 - 50 nm aufweisen, so kann man an der Oberfläche der Nanopartikel mehrere PTFE-Partikel anreichern. Auch hier kann man von den Prinzipien der sterischen Koagulation unter Zuhilfenahme von z. B. Polyelektrolyten Gebrauch machen, um eine bevorzugte Anreicherung an der Oberfläche zu erzielen.

Das Gemisch wird durch Elektrolyt-Zusatz und/oder intensives Rühren zum Koagulieren gebracht. Das Wasser wird abgetrennt, und das Material wird getrocknet. Durch Gleitmittelzugabe erhält man ein Material, aus dem ein Formkörper gepreßt werden kann. Die weitere Verarbeitung erfolgt in der oben beschriebenen Weise gemäß den Schritten c) - f).

Durch das Pastenextrudieren und/oder Kalandrieren mit anschließendem Recken und Ansintern wird die Knoten-Fibrillen-Struktur gebildet und verfestigt. Durch Einstellen des Reckverhältnisses läßt sich eine bestimmte Porengröße für den PTFE-Körper erreichen.

Der oben erwähnte Reckschritt f) stellt ein besonderes Merkmal des erfindungsgemäßen Materials dar, weil durch diesen Schritt eine Struktur entsteht, die man mit dem Begriff "Strickleiter" angemessen beschreiben kann. Das Recken und das Sintern des Materials gemäß Schritt e) führt zur Ausbildung von Knötchen und Fibrillen des PTFE, wie es an sich bekannt ist. Dieses Recken gemäß Schritt e) erfolgt in einer bestimmten Richtung (x-Richtung), so daß die die einzelnen Knötchen verbindenden Fibrillen eine gewisse Vorzugsrichtung, nämlich die x-Richtung, besitzen. Während der Weiterverarbeitung wird das streifenförmige gereckte PTFE beidseitig von Greifereinrichtungen erfaßt, die in Bewegungsrichtung der Materialbahn einen zunehmend größeren Abstand zueinander erhalten. Dadurch erfolgt ein Recken des Materials in zur Transportrichtung senkrechten Richtung (y-Richtung). Durch dieses Recken in y-Richtung entstehen aus den Knötchen in y-Richtung orientierte Hauptfibrillen oder Fibrillenbündel, die die "Stricke" der Strickleiter-Struktur darstellen. Im Fall von mit Nanopartikeln gefülltem PTFE erfolgt durch diesen zusätzlichen Reckvorgang eine weitergehende Verteilung der Füllstoffpartikel. Dies bedingt eine Homogenisierung. Größere Füllstoffpartikel würden die Räume zwischen den Fibrillen belegen; die Nanopartikel jedoch lagern sich auf den Oberflächen der Fibrillen und Fibrillenbündel ab.

Die durch das oben geschilderte Verfahren hergestellte Filtrations-Membran ist extrem dünn, erlaubt einen beträchtlich hohen Durchfluß, ist gegenüber konventionellen Membranen erheblich abriebfester und besitzt dennoch die unverändert guten Filtereigenschaften.

Im folgenden wird die Erfindung anhand von Beispielen näher erläutert. In den beigefügten Figuren zeigen:

**Fig. 1 bis 8**      Rasterelektronenmikroskop-Aufnahmen verschiedener ePTFE-Membranen mit und ohne Füllstoff, wobei

**Fig. 1A und 1B**      eine Aufnahme einer ungefüllten ePTFE-Membran in 2000-fächer bzw. 3500-facher Vergrößerung zeigen,

**Fig. 2A und 2B**      eine Aufnahme einer ePTFE-Membran mit 5 % $Al_2O_3$-Füllstoff in Form von Nanopartikeln in 2000-facher bzw. 3500-facher Vergrößerung zeigen,

**Fig. 3A und 3B** eine Aufnahme einer ePTFE-Membran mit 5 % $TiO_2$-Füllstoff in Form von Nanopartikeln in 2000-facher bzw. 3500-facher Vergrößerung zeigen,

**Fig. 4A und 4B** eine Aufnahme einer biaxial gereckten ePTFE-Membran ohne Füllstoff in 2000-facher bzw. 3500-facher Vergrößerung zeigen,

**Fig. 5A und 5B** eine Aufnahme einer biaxial gereckten ePTFE-Membran mit 5 % $Al_2O_3$-Füllstoff in Form von Nanopartikeln in einer 2000-fachen bzw. 3500-fächen Vergrößerung zeigen,

**Fig. 6A und 6B** eine biaxial gereckte ePTFE-Membran mit 5 % $TiO_2$-Füllstoff in Form von Nanopartikeln in 2000-facher bzw. 3500-facher Vergrößerung zeigen,

**Fig. 7** eine Aufnahme einer ePTFE-Struktur mit 10 % $Al_2O_2$-Füllstoff in Form von Nanopartikeln zeigt, hergestellt mit Hilfe von Ko-Koagulation, und

**Fig. 8** eine Aufnahme einer reinen ePTFE-Struktur, und

**Fig. 9** eine Aufnahme einer ePTFE-Struktur mit 10 % $Al_2O_3$-Füllstoff zeigt, wobei der Füllstoff gemäß dem Stand der Technik aus Partikeln einer Größe im Mikrometerbereich besteht.

Im folgenden werden Beispiele für das erfindungsgemäße Verfahren und den erfindungsgemäßen PTFE-Körper sowie Vergleichsbeispiele beschrieben, wobei hier als Beispiel eine ePTFE-Membran dienen soll, die für den Einsatz in einem Filter vorgesehen ist. Die ePTFE-Membran erfüllt nicht nur die Funktion eines Feinfilters, sie ist außerdem widerstandsfähig gegenüber einem Reinigungswerkzeug. Nach einer gewissen Betriebszeit wird die Oberfläche der ePTFE-Membran - wie bei Filtern üblich - von Ablagerungen befreit.

Dies geschieht üblicherweise mit Hilfe eines Abschabwerkzeugs, welches über die Oberfläche der Membran gezogen wird, um die dort befindlichen Ablagerungen zu entfernen. Die Abriebfestigkeit der Membran spielt also eine bedeutende Rolle, und zur Erhöhung der Abriebfestigkeit wird die Membran erfindungsgemäß mit Aluminiumoxid- oder Titanoxid-Partikeln einer Größe im Nanometerbereich gefüllt. Wie die Beispiele und die Vergleichsbeispiele zeigen werden, wird nicht nur eine sehr hohe Abriebfestigkeit erreicht, sondern auch die Zugfestigkeit wird gegenüber herkömmlichen Membranen erhöht. Dies ist unter anderem bei der Verarbeitung der Membran beim Filterbau wichtig.

Beispiel 1 (Dispersion)

In einer wassergekühlten Colloid-Mühle wurden 4000 ml Paraffinöl mit einem Siedepunkt zwischen 181°C bis 212°C vorgelegt. Dazu wurden unter Rühren 12 g Laurinsäure und dann langsam 600 g Aluminiumoxid ($Al_2O_3$) (Alpha UFX-MAR der Firma Chemag; Partikelgröße $d_{50}$ = 200 nm) gegeben. Diese Dispersion wurde in einem Feststoff-Flüssigkeits-Mischer (Patterson Kelly) zu einer darin vorgelegten Menge von 11,4 kg PTFE-Emulsionspolymerisat (Molekulargewicht > $10^7$, hergestellt gemäß der EP-A-0 170 382) in einem Zeitraum von 10 min zudosiert, und es wurde weitere 10 min gemischt.

Aus dieser Mischung wurde unter Vakuum bei 1,0 - 1,5 MPa ein Vorpressing in Form eines Pellets hergestellt.

Anschließend wurde durch Pastenextrusion ein Film (Tape) gebildet. Mit Hilfe beheizter Walzen wurde dieser Film auf die gewünschte Stärke , kalandriert (siehe nachstehende Tabelle 1, Beispiel 1.1 bis 2.4). Das Gleitmittel wurde thermisch entfernt. Hierzu wurde der Film nach dem Kalandrierschritt über beheizte Walzen (240°C - 250°C) geführt. Anschließend wurde der Film in Maschinenrichtung, d.h. in Transportrichtung, bei 240°C gereckt (200 %/s) und bei Temperaturen > 330°C angesintert. Man erhielt ein uniaxial gerecktes Band mit der typischen expandierten Knoten-Fibrillen-Struktur. Die Eigenschaften dieses Bandmaterials sind in Tabelle 2 angegeben.

Beispiel 2 (Dispersion)

Es wurde wie im Beispiel 1 verfahren, um ein gefülltes Band (Tape) herzustellen, welches aber anstelle der 600 g Aluminiumoxid nun Titandioxid (R-320 der Firma Hombitan; Partikelgröße $d_{50}$ = 200-300 nm) enthielt. Die Eigenschaften dieses Materials sind ebenfalls in den Tabellen 1 und 2 angegeben.

Beispiel 3 (Dispersion)

In einer wassergekühlten Kolloid-Mühle wurden 400 ml eines Gleitmittels vorgelegt, bestehend aus einem Teil Isopropylalkohol und zwei Teilen Polypropylenglykol. Dazu wurden unter Rühren 1200 g Aluminiumoxid (A16SG der Firma Alcoa; Partikelgröße $d_{50}$ = 300 nm) gegeben. Diese Dispersion wurde mit einem Feststoff-Flüssigkeits-Mischer (Patterson Kelly) zu vorgelegtem 10,8 kg PTFE-Emulsionspolymerisat (Molekulargewicht > $10^7$, hergestellt gemäß der EP-A-0 170 382) in einem Zeitraum von 10 min zudosiert, und es wurde weitere 10 min gemischt. Aus dieser Mischung wurde bei 1,4 - 1,5 MPa unter Vakuum ein Pellet hergestellt. Durch anschließende Pastenextrusion wurde ein Film (Tape) gebildet, der mittels beheizter Walzen auf die gewünschte Dicke kalandriert wurde (vgl. Tabelle 1). Das Gleitmittel wurde thermisch entfernt, indem der Film über beheizte Walzen (340°C - 250°C) geführt wurde. Anschließend wurde der Film in Maschinen- oder Arbeitsrichtung bei 240°C gereckt (200 %/s) und bei Temperaturen > 330°C angesintert. Man erhielt ein uniaxial gerecktes Band mit expandierter Knoten-Fibrillen-Struktur von PTFE. Die Eigenschaften sind in Tabelle 2 angegeben.

Vergleichsbeispiel A (ohne Nanopartikel)

3460 ml Paraffinöl mit einem Siedepunkt von 181°C bis 212°C wurden in einen Feststoff-Flüssigkeits-Mischer (Patterson Kelly) zu vorgelegtem 12,0 kg PTFE-Emulsionspolymerisat (Molekulargewicht > $10^7$, hergestellt gemäß der EP-A-0 170 382) in einem Zeitraum von 10 Minuten zudosiert, und es wurde weitere 20 Minuten gemischt. Aus dieser Mischung wurde bei 1,4 bis 1,5 MPa unter Vakuum ein Pellet hergestellt. Durch nachfolgende Pastenextrusion erhielt man einen Film (Tape), der mittels beheizter Walzen auf die gewünschte Starke kalandriert wurde (vgl. Tabelle 1). Entfernt wurde das Gleitmittel thermisch, indem man den Film über beheizte Walzen (240°C - 250°C) führte. Anschließend wurde der Film in Maschinenrichtung bei 240°C gereckt (200 %/s) und bei 356°C angesintert. Man erhielt ein unidirektional gerecktes Band oder Tape mit typischer expandierter Knoten-Fibrillen-Struktur. Die Eigenschaften sind in Tabelle 1 und 2 angegeben.

Tabelle 1:

| Unaxiales Recken - Sintern der Filme | | | |
|---|---|---|---|
| Film | | Dicke nach Kalandrieren in µm | Reckverhältnis |
| Beispiel 1 PTFE + 5 % $Al_2O_3$ | | | |
| | 1,1 | 284 | 3,5:1 |
| | 1,2 | 147 | 3,5:1 |
| | 1,3 | 70 | 3,5:1 |
| | 1,4 | 38 | 5:1 |
| Beispiel 2 PTFE+ 5 % $TiO_2$ | | | |
| | 2.1 | 280 | 3,5:1 |
| | 2.2 | 143 | 3,5:1 |
| | 2.3 | 84 | 3,5:1 |
| | 2.4 | 45 | 5:1 |
| Vergleichsbeispiel PTFE | | | |
| | A1 | 282 | 3,5:1 |
| | A2 | 153 | 3,5:1 |
| | A3 | 75 | 3,5:1 |
| | A4 | 65 | 5:1 |
| Beispiel 3 PTFE + 10 % $Al_2O_3$ | | | |
| | 3 | 153 | 2,0:1 |
| | | | |

**EP 0 951 500 B1**

Tabelle 2:

| Struktureigenschaften der uniaxial gereckten Filme | | | | |
|---|---|---|---|---|
| Film | | Schmelzwärme J/g | Schmelzbereich °C | MFP*µM |
| Beispiel 1 PTFE+ $Al_2O_3$ (5%) | | | | |
| | 1,1 | 61,9 | 347,4 - 342,2 | 0,6 |
| | 1,2 | 55,2 | 346,4 - 340,4 | 0,6 |
| | 1,3 | 39,8 | 341,1 - 338,0 | 0,6 |
| | 1,4 | 30,3 | 334,7 - 344,4 | 1,0 |
| Beispiel 2 PTFE+ $TiO_2$ (5%) | | | | |
| | 2.1 | 61,2 | 346,7 - 339,7 | 0,3 |
| | 2.2 | 50,5 | 346,4 - 339,7 | 0,5 |
| | 2.3 | 37,2 | 337,5 | 0,4 |
| | 2.4 | 25,8 | 333,5 | 1,1 |
| Vergleichsbeispiel PTFE | | | | |
| | A1 | 61,4 | 345,6 | 0,36 |
| | A2 | 54,4 | 346,1 - 339,8 | 0,5 |
| | A3 | 36,8 | 337,3 | 0,4 |
| | A4 | 30,0 | 334,1-345,2 | 0,7 |
| Beispiel 3 + $Al_2O_3$ (10%) | | | | |
| | 3 | 34,4 | 336,0 | 0,53 |

* (mittlerer Porendurchmesser) $d_{50}$

Vergleicht man die Eigenschaften der nach den obigen Beispielen und dem Vergleichsbeispiel A hergestellten Filme, so sieht man, daß sich durch die Nanopartikel-Füllstoffe hergestellten Membranen in ihren Struktureigenschaften praktisch nicht unterscheiden von Membranen ohne Füllstoff. Das heißt, daß mit diesen Membranen die gleichen spezifischen Vorteile erzielt werden, wie sie auch bislang mit ungefüllten PTFE-Membranen erzielt wurden. Hinzu kommen aber noch spezielle Eigenschaften aufgrund des Füllstoffs. Diese Eigenschaften werden weiter unten noch angesprochen. Insbesondere handelt es sich hier um die durch den Füllstoff gezielt eingestellte hohe Abriebfestigkeit der ePTFE-Membran.

Beispiel 4

Die gemäß den obigen Beispielen 1 und 2 sowie nach dem Vergleichsbeispiel A hergestellten Filme wurden im Anschluß an die Fertigungsprozedur ein zweitesmal gereckt, und zwar senkrecht zur Maschinenrichtung (transvers). Dieser Reckvorgang erfolgte in der genannten Querrichtung bei Temperaturen oberhalb des kristallinen Schmelzpunkts der Filme (vgl. Spalte "Schmelzbereich" in der Tabelle (2)). Das Reckverhältnis betrug 5:1 bis 10:1.

Tabelle 3: Eigenschaften der biaxial gereckten Filme

| Film | | Dicke in μm | Reckverhältnis | Geschwindigkeit[1] m/min | Schmelzbereich °C | MFP μm | mTS (T)[2] N/mm² | mTS (M)[3] N/mm² |
|---|---|---|---|---|---|---|---|---|
| Vergleichsbeispiel A | 4A1 | 60 | 10:1 | 5 | 340,1 - 328,9 | 0,7 | 82 | 64 |
| | 4A2 | 24 | 10:1 | 5 | 345,3 | 0,8 | 152 | 67 |
| | 4A3 | 11 | 10:1 | 20 | 338,9 | 1,0 | 260 | 83 |
| | 4A4 | 7 | 10:1 | 20 | 339,7 | 1,1 | 108 | 144 |
| 5% Al₂O₃ | 4.1.1. | 50 | 10:1 | 15 | 333,3 | 0,8 | 80 | 52 |
| | 4.1.2. | 20 | 10:1 | 20 | 334,8 | 0,8 | 120 | 59 |
| | 4.1.3. | 8 | 10:1 | 20 | 341,1 - 335,6 | 1,5 | 171 | 75 |
| | 4.1.4. | 2 - 3 | 10:1 | 5 | 335,2 | 1,4 | 116 | 183 |
| 5% TiO₂ | 4.2.1. | 55 | 10:1 | 20 | 339,2 - 329,2 | 0,8 | 166 | 62 |
| | 4.2.2. | 16 | 10:1 | 20 | 336,4 | 0,5 | 68 | 152 |
| | 4.2.3. | 13 | 10:1 | 20 | 340,4 | 1,5 | 222 | 106 |
| | 4.2.4. | 5 - 6 | 5:1 | 20 | 337,2 - 331,7 | 1,5 | 86 | 259 |

[1]Maschinengeschwindigkeit
[2]Matrix Tensile Strength (Transverse); Matrix-Reißfestigkeit in Querrichtung der Maschinenrichtung
[3]Matrix Tensile Strength; Matrix-Reißfestigkeit in Maschinen- oder Transportrichtung

Die Ergebnisse gemäß Tabelle 3 belegen, daß sich auch bei diesem Beispiel 4 die Struktureigenschaften der Membranen nicht ändert.

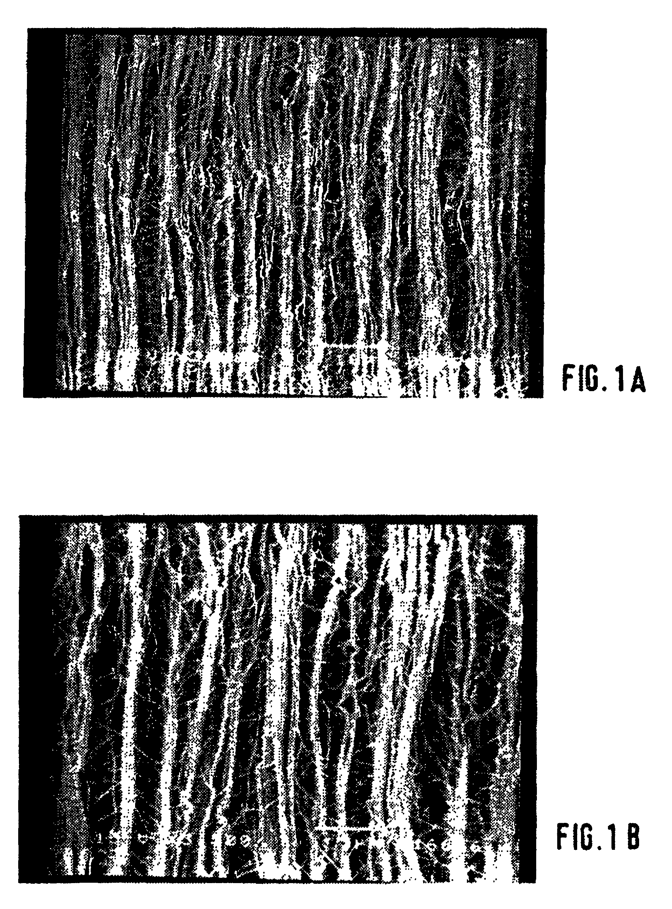

Dies wird auch deutlich durch einen Vergleich der Fig. 1, 2 und 3.

Die Fig. 1A und 1B zeigen eine Rasterelektronenmikroskop-Aufnahme einer ePTFE-Membran ohne Füllstoff. Man erkennt deutlich die Fibrillenstruktur, die sich vertikal durch die beiden Aufnahmen erstreckt.

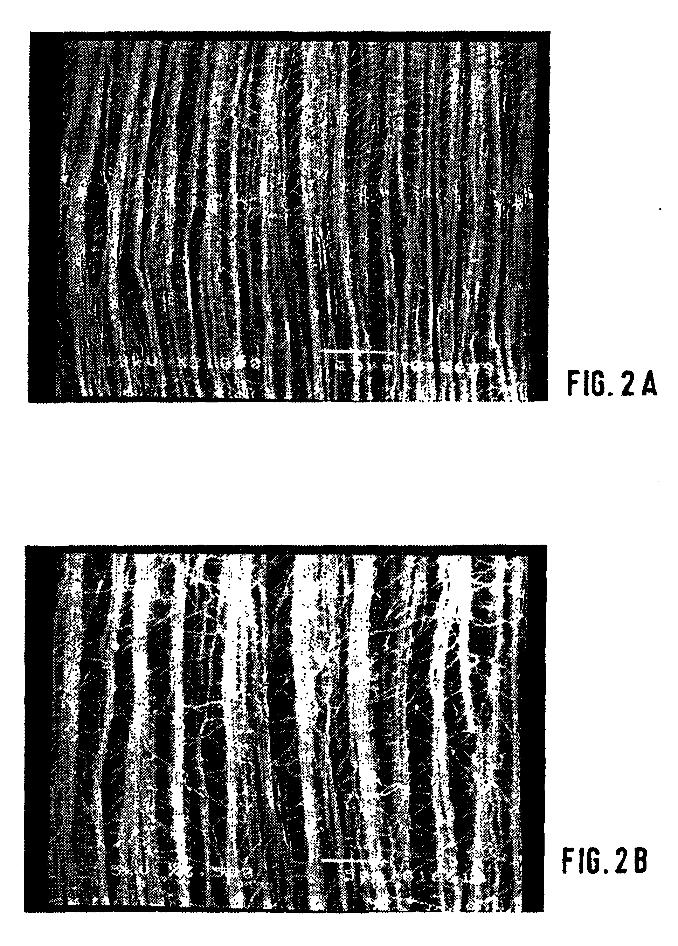

Fig. 2A und 2B zeigen in unterschiedlicher Vergrößerung (2000-fach bzw. 3500-fach) eine ähnliche ePTFE-Membran, jedoch hier mit einem Nanopartikel-Füllstoff, nämlicht 5 % Al₂0₃, hergestellt gemäß vorliegendem Beispiel 4. Vergleicht man die Fig. 1 und 2, so wird deutlich, daß sich trotz des Füllstoffs an der Struktur der Membran praktisch nichts geändert hat.

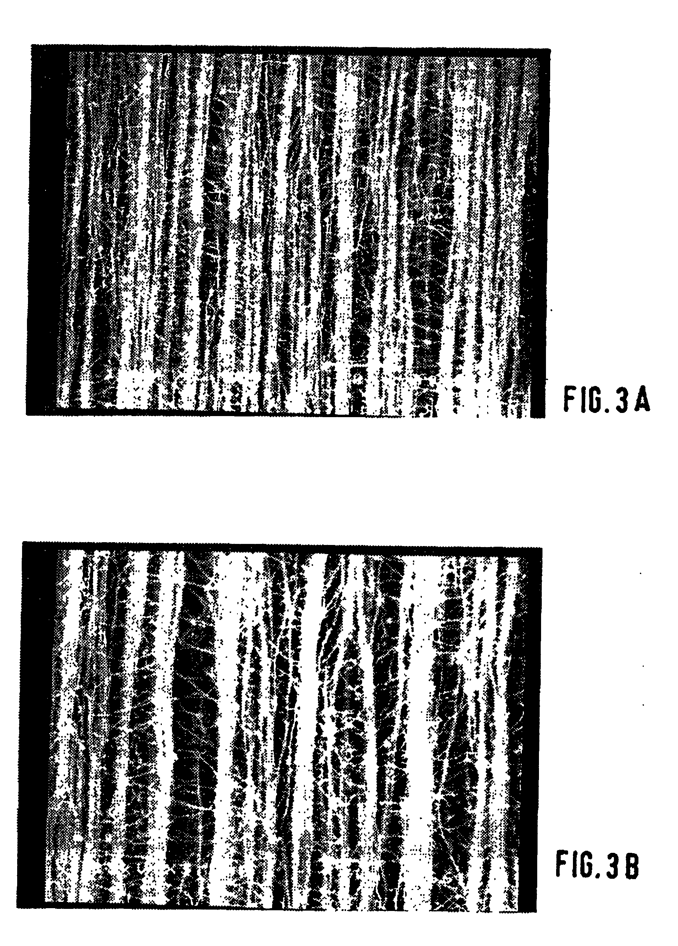

Das gleiche gilt für die in den Fig. 3A und 3B dargestellte Struktur einer ePTFE-Membran, bei der der Nanopartikel-Füllstoff aus 5 % $TiO_2$ besteht. Auch hier ist die Struktur gegenüber dem ungefüllten ePTFE praktisch unverändert.

Zwischen den relativ dicken vertikal verlaufenden Fibrillenbündeln, die durch den zweiten Reckvorgang (quer zur Maschinenrichtung) entstehen, befinden sich kleine dünne quer verlaufende Fibrillen. Mit anderen Worten: die dicken, von oben nach unten in der Zeichnung verlaufenden Hauptfibrillen sind untereinander in Querrichtung vernetzt.

Beispiel 5

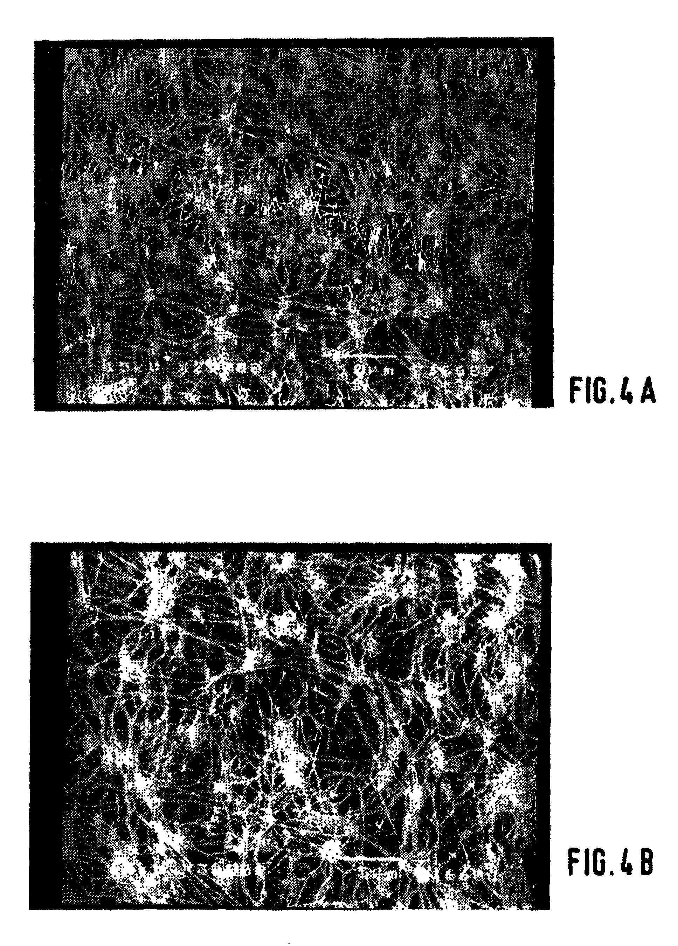

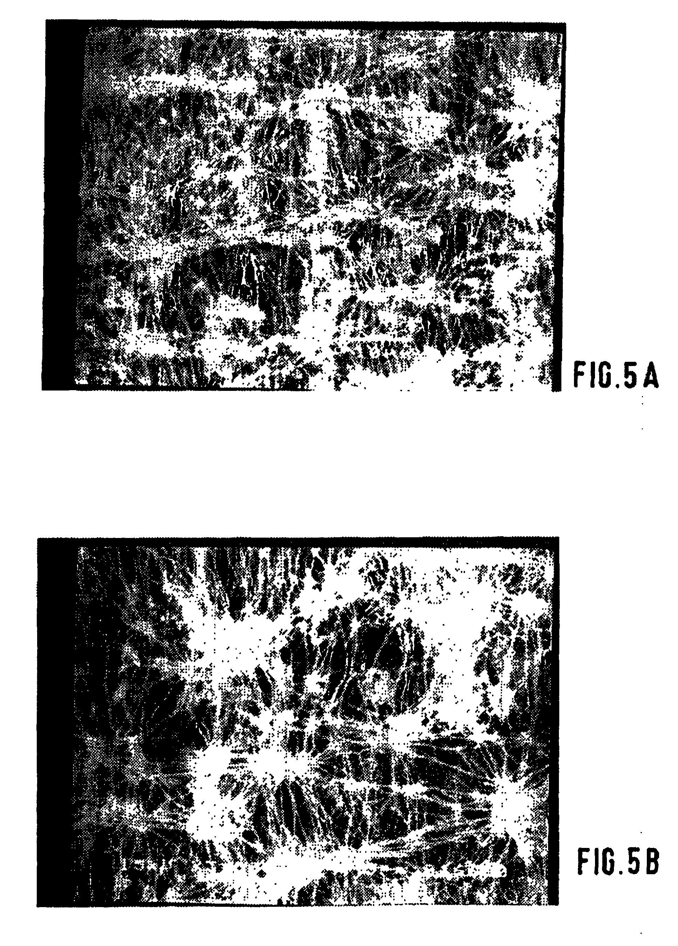

Es wurde wie beim Beispiel 1 vorgegangen, jedoch wurde nicht unidirektional gereckt, sondern biaxial. Im Gegensatz zum obigen Beispiel 4 erfolgte aber das Recken nicht oberhalb, sondern unterhalb des kristallinen Schmelzpunkts. Nach dem Recken wurde der Film gesintert. Es ergab sich die bekannte Struktur von expandiertem, porösem PTFE gemäß Fig. 5. Ein Vergleich der Fig. 4 und 5 zeigt, daß sich in der Struktur praktisch kaum Unterschiede ergeben. Dies ist Beweis dafür, daß die Nanopartikel Bestandteil der ursprünglichen ePTFE-Struktur sind.

Beispiel 6

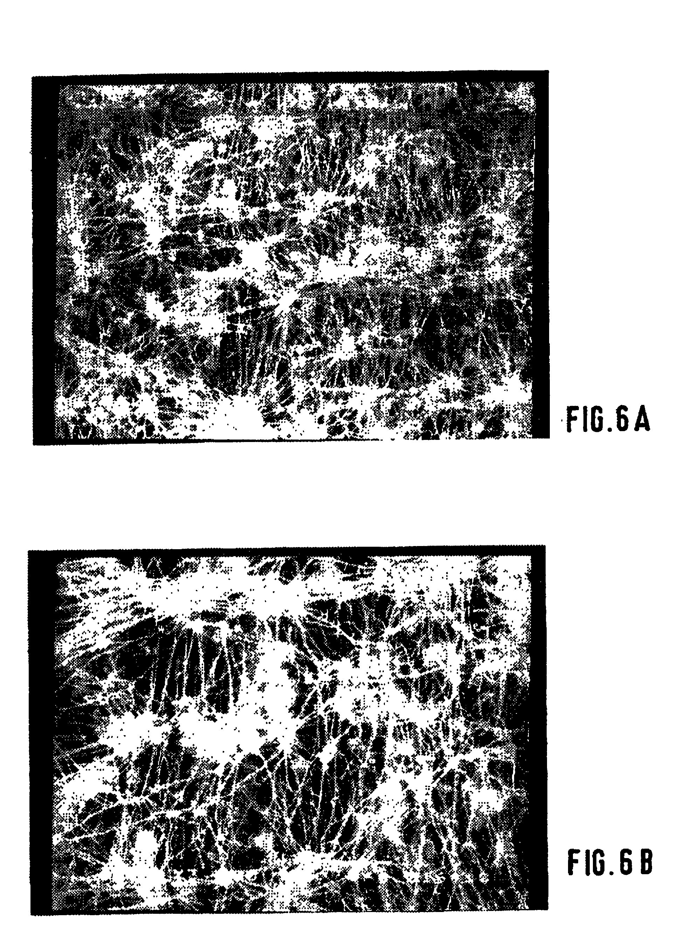

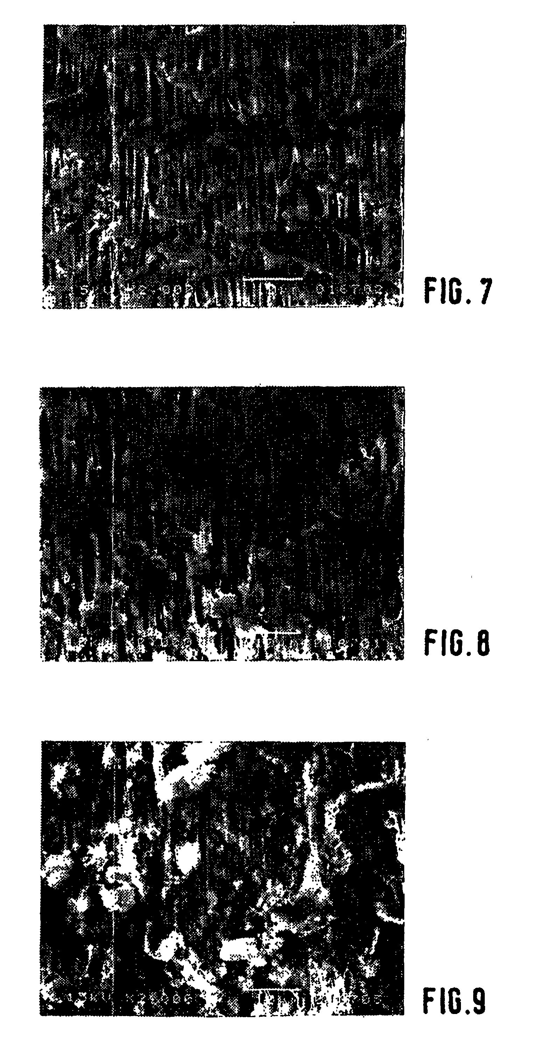

Es wurde wie in Beispiel 2 vorgegangen, wobei ebenfalls wie im obigen Beispiel 5 biaxial bei Temperaturen unterhalb des kristallinen Schmelzpunkts gereckt wurde. Man erhielt hierdurch den Film mit der in Fig. 6 dargestellten Struktur.

Vergleichsbeispiel B

Gemäß den obigen Beispielen 5 und 6 wurde auch das Vergleichsbeispiel A modifiziert, indem unterhalb des kristallinen Schmelzpunkts biaxial gereckt wurde. Die dadurch erhaltene Struktur der PTFE-Membran ist in Fig. 4 dargestellt.

Beispiel 7 (Ko-Koagulation)

Es wurden 540 g vollionisiertes Wasser in ein Glas gegeben. Mit HCl wurde ein pH-Wert von 2-3 eingestellt. 19,5 g Aluminiumoxid mit einer Partikelgröße von $d_{50}$ = 13 nm (Degussa) wurden langsam unter Rühren zugegeben. Die $Al_2O_3$-Dispersion wurde zu 740,5 g einer 23,7-Masseprozentigen PTFE-Dispersion gegeben. Nach Zugabe von 24,4 ml einer 0,5-%igen Sedipurlösung (BASF) erreichte man unter Rühren die Ko-Koagulation des Stoffgemisches. Der Feststoff wurde filtriert und 8 Stunden bei 165°C getrocknet.

17,5 ml Paraffinöl wurden zu 56,7 g des Gemisches gegeben, und es wurde ein Formkörper her gestellt, indem man das Material bei 0,35 MPa verpreßte. Durch anschließende Pastenextrusion bei 15,0 MPa, anschließendes thermisches Entfernen des Gleitmittels bei 250 °C und nachfolgendes Recken bei etwa 300°C (25:1) bei einer Rate von etwa 1000 %/s erhielt man einen Film, dessen Struktur in Fig. 7 dargestellt ist. Der Versuch wurde wiederholt, indem ein anderes Aluminiumoxid verwendet wurde (A16 SG, Alcoa). Als Koagulant wurde eine 25 %ige Aluminiumnitratlösung verwendet (siehe Tabelle 4). Der Versuch wurde nochmals wiederholt, indem 5% des Aluminiumoxids durch PFA-Dispersion (Tetrafluorethylen-Perfluorpropylvinylether-Copolymer, Hoechst AG, Partikelgröße $d_{50}$, ca. 50 nm) ersetzt wurde (Tabelle 4).

Der Versuch wurde nochmals wiederholt, wobei nur eine PTFE-Dispersion ohne Füllstoff verwendet wurde (vgl. Tabelle 4).

Beispiel 8 (Trockenmischung)

113,4 g einer Mischung aus zehn Teilen Aluminiumoxid (Partikelgröße $d_{50}$ = 13 nm; Degussa) und 90 Teilen PTFE-Emulsionspolymerisat (Molekulargewicht > $10^7$, hergestellt gemäß der EP-A-0 170 382) wurden mit 60 ml Paraffinöl versehen. Daraus stellte man einen Formkörper her, indem man das Material bei 0,35 MPa verpreßte. Anschließend erfolgt bei 34,0 MPa eine Pastenextrusion. Das Gleitmittel wurde thermisch bei 250°C entfernt. Ein nachfolgendes Recken erfolgte bei etwa 300°C (25:1) bei einer Rate von ungefähr 1000 %/s.

Vergleichsbeispiel C

113,4 g einer Mischung aus zehn Teilen Aluminiumoxid (ZS203 der Firma Martinswerk, Alphaform des Alu-

miniumoxids, $d_{50}$ ca. 3 μm) und 90 Teilen PTFE-Emulsionspolymerisat (Molekulargewicht > $10^7$, gefertigt gemäß der EP-A-0 170 382) wurden mit 40 ml Paraffinöl versehen. Daraus stellte man einen Formkörper her, indem man das Material bei 0,35 MPa verpreßte. Anschließend erfolgte bei 19,0 MPa eine Pastenextrusion. Das Gleitmittel wurde thermisch bei 200°C entfernt. Eine nachfolgende Reckung erfolgte bei etwa 300°C (25:1) bei einer Rate von ungefähr 1000 %/s.

Die Partikel des Füllstoffs sind im Rasterelektronenmikroskop-Bild deutlich sichtbar, wie Fig. 9 zeigt. Die Füllstoffpartikel, die eine Größenordnung von einigen Mikrometern haben, haben die ursprüngliche ePTFE-Struktur zerstört.

Tabelle 4:

| Eigenschaften der uniaxial gereckten Filme | | | | | |
|---|---|---|---|---|---|
| Zusammensetzung | | Extrusionsdruck MPa | Dichte der gereckten Filme in $gcm^{-3}$ | Reißdehnung (%) | mTS $N/mm^2$ |
| Beispiel 7 | PTFE | 16,5 | 0,33 | 59 | 94 |
| | 10% Degussa* | 15,0 | 0,23 | 67 | 77 |
| | 10% Al6SG | 18,5 | 0,37 | 74 | 80 |
| | 5% Al6SG + 5% PFA | 16,5 | 0,22 | 73 | 85 |
| | | | | | |
| Beispiel 8 | 10% Degussa | 24,0 | 0,30 | 42 | 84 |
| | | | | | |
| Vergleichsbeispiel C | 10% ZS 203 | 19,0 | 0,17 | 36 | 56 |

\* Eine thermogravimetrische Analyse ergab 9,99 Masseprozent an Aluminiumoxid

Test

Die gemäß obigen Beispielen hergestellten Membranen wurden mit einem Scheuerfestigkeitstest nach Martindale (Pilling Verfahren mit Wolle) getestet (Prüfvorschrift gemäß Schweizer Norm SN 198525). Verglichen wurde eine Membran des Vergleichsbeispiels A mit einer mit $TiO_2$ (5 %) gefüllten Membran. Die mit $TiO_2$ gefüllte Membran hatte eine 5-fach erhöhte Widerstandsfähigkeit gegenüber Abrieb: Die Membran gemäß Vergleichsbeispiel hielt 250 Zyklen des Scheuertests stand, die mit $TiO_2$ gefüllte Membran hingegen 1210 Zyklen. Die Membrandicke betrug 4 bis 7μm.

Die Matrix-Zugfestigkeit mTs wurde mit Hilfe eines Instrons geprüft (Instron Corporation Series IX-Automatic Material Testing System 1.09) gemäß DIN 53888. Die Proben waren 15 mm breit. Der Abstand zwischen den Halteklemmen betrug 50 mm. Die Probe wurde mit einer Geschwindigkeit von 100 mm/min bei 20°C und 65 % Feuchtigkeit gezogen. Durch die Maschine wurden die Längung und der Widerstand unmittelbar vor dem Bruch aufgezeichnet.

Das Molekulargewicht wurde gemäß folgender Formel bestimmt:

$$MW_n^* = 0,597 \log \frac{0,157^{-1}}{2,306 - SSG} \times 10^6$$

wobei SSG = spezifisches Gewicht von PTFE. Man kann SSG gemäß den ASTM-Normen D1457-62 T und D727-60T berechnen.

\* R.C. Doban et al American Chemical Society Meeting in Atlantic City, N.J. - September 1956.

Die Daten für die Partikelgröße kommerziell beziehbarer anorganischer Stoffe wurden den Datenblättern des Herstellers entnommen.

Messung des durchschnittlichen Porendurchmessers (mean flow pore size MFP $d_{50}$):

Es wurde eine Probenmembrane mit einem Durchmesser von 25 mm mit Perfluorpolyether benetzt. Die benetzte Membrane wurde in ein Coulter-Porometer eingebracht, wodurch der mittlere Porendurchmesser des Endprodukts bestimmt wurde.

Thermoanalyse (DSC = Differential Scanning Calorimetry (DSC):

Mit Hilfe des DSC-Verfahrens wurden Änderungen des Schmelzverhaltens in Abhängigkeit der Verarbeitung untersucht. Die Messungen erfolgten mit Hilfe des Geräts Perkin Eimer DSC 7, welches gemäß In - und Pb-Norm kalibriert war (Meßtemperaturbereich: 200 - 400°C, Zyklus: erstes Erwärmen - Abkühlen - zweites: Erwärmen; Heizrate: 10 K/min, Atmosphäre: reiner Stickstoff; Probengewicht: etwa 10,0 mg für ePTFE. Um das Schmelzverhalten von ePTFE zu charakterisieren, wurde die Schmelztemperatur $T_{max}$ der ersten Erwärmung herangezogen (vgl. Tabelle 2 und 3).

Untersuchung mittels Rasterelektronenmikroskopie (SEM = Scanning Electron Microscopy):

Eine Membranprobe wurde mit Gold besputtert und in dem Rasterelektronenmikroskop unter Vakuum vermessen. Das Rasterelektronenmikroskop war ein Gerät Jeol, JSM4500, beziehbar von der Firma Contron Electronik, Deutschland.

Beispiel 9 (Ko-Koagulation) HYDROPHILE MEMBRAN:

26,3 kg wäßrige hochmolekulare PTFE-Dispersion (E.I. DuPont de Nemours Co., Inc.) wurde mit 10 1 Wasser verdünnt und zu einer Dispersion von 300g Aluminiumoxid (Aluminiumoxid C, Degussa, $d_{50}$ = 13 nm) in 23,4 l Wasser gegeben. Der pH-Wert der Dispersion mit einem Feststoffgehalt von 10 Masseprozent betrug 3. Diese Mischung wurde durch kräftiges Rühren koaguliert. Nach der vollständigen Ko-Koagulation wurde der Feststoff durch Filtration vom Wasser befreit, gewaschen und in einem Umluftofen für 24 h getrocknet. Nach dem Trocknen betrug der Restwassergehalt < 0,2 Masseprozent, der Aluminiumoxidanteil wurde zu 4,6 Masseprozent bestimmt. Zu 5,87 kg des Komposits gab man einen aliphatischen Kohlenwasserstoff, so daß der Anteil des bei 170°C bis 210°C siedenden Gleitmittels 22,1 Masseprozent betrug. Unter Druck wurde daraus ein zylindrisches Pellet geformt und durch eine Flachdüse extrudiert. Man erhielt ein Tape, das ca. 660µm dick war und eine Breite von 16,5 cm aufwies. Dieses Tape wurde mittels Rollen auf eine Dicke von 150µm kalandriert. Nach dem thermischen Entfernen des Gleitmittels wurde das extrudierte und kalandrierte Tape bei 250°C und einem Verhältnis von 3:1 in Maschinenrichtung gereckt und thermisch fixiert, indem das Material über beheizte Rollen (350°C) geführt wurde. Dieses expandierte Tape wurde in einem auf 360°C beheizten Ofen 5:1 transvers zu einer Membran gereckt. Der gleiche Prozeß wurde wiederholt, indem man unter identischen Bedingungen eine Vergleichsmembran aus einer PTFE-Dispersion herstellte und Membranen, die einen Aluminiumoxidanteil von 9,3; 12,6 und 17,8 Masseprozent in der Membran aufwiesen. Die Membraneigenschaften sind in der Tabelle angegeben.

Tabelle 5:

| Bestimmung des Wassereintrittsdruckes und der Wasserdampfdurchlässigkeit hydrophilierter Tapes | | | | |
|---|---|---|---|---|
| Membran | Dicke µm | WEP[1] [MPa] | MFP[2] µm | MVTR g/m²24h |
| Beispiel 9 PTFE | 27 | 0,23 | 0,58 | > 75000 |
| Beispiel 9 PTFE + 4,6 Masseprozent Al₂0₃ | 30 | 0,20 | 0,60 | > 75000 |
| Beispiel 9 PTFE + 9,3 Masseprozent Al₂0₃ | 26 | 0,19 | 0,58 | > 75000 |
| Beispiel 9 PTFE + 12,6 Masseprozent Al₂0₃ | 27 | 0,15 | 0,56 | > 75000 |

WEP[1] Water Entry Pressur (Wassereintrittsdruck);

MFP[2] Mean Flow Pore Size (mittl. Porendurchmesser)

Beispiel 10 (Ko-Koagulation);

31,9 kg wäßrige hochmolekulare PTFE-Dispersion (E.I. DuPont de Nemours Co., Inc.) wurde mit 8,1 l Wasser verdünnt und zu einer Dispersion von 800 g Titandioxid (TTO-51 A, Ishihara Sangyo Kaisha, Ltd.; $d_{50}$ = 20 nm) in 30,01 Wasser gegeben. Der pH-Wert der Dispersion mit einem Feststoffgehalt von 12 Masseprozent betrug 3. Diese Mischung wurde durch kräftiges Rühren kokoaguliert. Nach der vollständigen Ko-Koagulation wurde der Feststoff durch Filtration vom Wasser befreit, gewaschen und in einem Umluftofen für 24h getrocknet. Nach dem Trocknen betrug der Restwassergehalt < 0,2 Masseprozent, der Titandioxidanteil wurde zu 8,3 Masseprozent bestimmt. Zu dem Komposit gab man einen aliphatischen Kohlenwasserstoff, so daß der Anteil des bei 170°C bis 210°C siedenden Gleitmittels 0,47 l/kg betrug. Unter Druck wurde daraus ein zylindrisches Pellet geformt und durch eine Flachdüse extrudiert. Man erhielt ein Tape, das ca. 660μm dick war und eine Breite von 16,5 cm aufwies. Dieses Tape wurde mittels Rollen auf eine Dicke von 150μm kalandriert. Nach dem thermischen Entfernen des Gleitmittels wurde das extrudierte und kalandrierte Tape bei 250°C und einem Verhältnis von 3:1 in Maschinenrichtung gereckt und thermisch fixiert, indem das Material über beheizte Rollen (350°C) geführt wurde. Dieses expandierte Tape wurde in einem auf 360°C beheizten Ofen 5:1 transvers zu einer Membran gereckt.

Beispiel 11 (Ko-Koagulation):

23,9 kg wäßrige hochmolekulare PTFE-Dispersion (E.I. DuPont de Nemours Co., Inc.) wurde mit 6,0 l Wasser verdünnt und zu einer Dispersion von 600g Titandioxid (Hombitan % 320, Sachtleben Chemie; $d_{50}$ = 200-300 nm) in 24,5 1 Wasser gegeben. Diese Mischung wurde durch kräftiges Rühren kokoaguliert. Nach der vollständigen Ko-Koagulation wurde der Feststoff durch Filtration vom Wasser befreit, gewaschen und in einem Umluftofen für 24h getrocknet. Nach dem Trocknen betrug der Restwassergehalt < 0,2 Masseprozent, der Titandioxidanteil wurde zu 7,9 Masseprozent bestimmt. Zu dem Komposit gab man einen aliphatischen Kohlenwasserstoff, so daß der Anteil des bei 170°C bis 210°C siedenden Gleitmittels 0,300 l/kg betrug. Unter Druck wurde daraus ein zylindrisches Pellet geformt und durch eine Flachdüse extrudiert. Man erhielt ein Tape, das ca. 664 μm dick war und eine Breite von 16,5 cm aufwies. Dieses Tape wurde mittels Rollen auf eine Dicke von 150μm kalandriert. Nach dem thermischen Entfernen des Gleitmittels wurde das extrudierte und kalandrierte Tape bei 250°C und einem Verhältnis von 3:1 in Maschinenrichtung gereckt und thermisch fixiert, indem das Material über beheizte Rollen (350°C) geführt wurde. Dieses expandierte Tape wurde in einem auf 360°C beheizten Ofen 5:1 transvers zu einer Membran gereckt. Wie aus Tabelle 6 ersichtlich ist, bewirken Zusätze von ca. 8% $TiO_2$ mit einer Partikelgröße von 20 bis 300 nm in PTFE-Membranen einen sicheren Schutz vor UV-Strahlen. Die UV-Durchlässigkeit im angegebenen Bereich ist Null.

Tabelle 6:

| UV-Durchlässigkeit der PTFE-Kompositmembranen | | |
|---|---|---|
| Membran | Dicke μm | UV-Verhalten |
| Beispiel 9 PTFE | 27 | UV-durchlässig im Bereich 250 bis 400nm |
| Beispiel 10 PTFE + 8,3 Masseprozent $TiO_2$ | 22 | UV-undurchlässig im Bereich von 250 bis 380nm |
| Beispiel 11 PTFE + 7,9 Masseprozent $TiO_2$ | 24 | UV undurchlässig im Bereich von 250 bis 380nm |
| Experimentelle Bedingungen: Gerät: Lambda 19 der Firma Perkin Elmer Wellenlängenbereich: 250 - 810nm Geschwindigkeit: 120nm/min; Spaltbreite 1,00 nm; 1 Datenpunkt pro 0,4 nm aufgenommen Glättung: 1,00 | | |

Die Proben wurden in Transmission vermessen, indem sie am Austrittsbereich der Küvettenhalterung glatt gespannt wurden. Es erfolgte Basislinienabgleich.

**Herstellung eines beschrifteten Rundkabels**

Ein nach Beispiel 11 hergestelltes Tape mit einer Dicke von 100 µm nach dem Kalandrieren und einem Titandioxidgehalt von 7,8 Masseprozent wird zur Herstellung eines Rundkabels genutzt. Dazu wickelt man das Tape um einen Leiter mit einem Durchmesser von 1,016 mm (20 AWG: American Wire Gauge), bis die Wandstärke der Isolation 0,25 mm erreicht hat. Dieses Kabel wird mit Hilfe eines UV Excimer Lasers (Spectrum Technologies) beschriftet. Vergleicht man die vorliegende Kabelbeschriftung mit der Beschriftung eines nach US 5.501.827 hergestellten Kabels, so beobachtet man einen ausgezeichneten Kontrast. Der verbesserte Kontrast ist auf die Verwendung feinteiliger Partikel in der PTFE-Matrix zurückzuführen (US 5.501.827 verwendet $TiO_2$ einer Partikelgröße zwischen 1 und 12 µm).

Beispiel 12 (Ko-Koagulation):

24,9 kg wäßrige hochmolekulare PTFE-Dispersion (E.I. DuPont de Nemours Co., Inc.) wurde mit 10,0 l Wasser verdünnt und zu einer Dispersion von 300 g Zirkondioxid (Versuchsprodukt, Degussa; $d_{50}$ = 30 nm) in 24,8 l Wasser gegeben. Diese Mischung wurde durch kräftiges Rühren kokoaguliert. Nach der vollständigen Ko-Koagulation wurde der Feststoff durch Filtration vom Wasser befreit, gewaschen und in einem Umluftofen für 24h getrocknet. Nach dem Trocknen betrug der Restwassergehalt < 0,2 Masseprozent, der Titandioxidanteil wurde zu 5,3 Masseprozent bestimmt. Zu dem Komposit gab man einen aliphatischen Kohlenwasserstoff, so daß der Anteil des bei 170°C bis 210°C siedenden Gleitmittels 0,282 l/kg betrug. Unter Druck wurde daraus ein zylindrisches Pellet geformt und durch eine Flachdüse extrudiert. Man erhielt ein Tape, das ca. 660µm dick war und eine Breite von 16,5 cm aufwies. Dieses Tape wurde mittels Rollen auf eine Dicke von 150µm kalandriert. Nach dem thermischen Entfernen des Gleitmittels wurde das extrudierte und kalandrierte Tape bei 250°C und einem Verhältnis von 3:1 in Maschinenrichtung gereckt und thermisch fixiert, indem das Material über beheizte Rollen (350°C) geführt wurde. Dieses expandierte Tape wurde in einem auf 360°C beheizten Ofen 5:1 transvers zu einer Membran gereckt. Der gleiche Prozeß wurde wiederholt, indem man unter identischen Bedingungen Membranen herstellte, die einen Zirkondioxidanteil von 9,3 und 12,6 Masseprozent in der Membran aufwiesen.

Es wurden Abriebsuntersuchungen durchgeführt, die belegen, daß PTFE-Komposites eine Verbesserung des Abriebverhaltens bewirken.

Tabelle 7:

| Abriebverhalten von PTFE-Membranen | | |
|---|---|---|
| Membran | Dicke µm | Scheuerzyklen* |
| Beispiel 9 PTFE | 27 | 750 |
| Beispiel 12 PTFE + 9,3 Masseprozent $ZrO_2$ | 35 | 1750 |

\* Scheuertest in Anlehnung an DIN 53863 nach Martindahle. Filzunterlage war Wolle, Belastung 12 kPa, angegeben sind die Zyklen, die die Membran ohne Lochbildung besteht;

Die Lochbildung wurde mittels eines Sutertests ermittelt:

Die gescheuerte Probe wird auf einen Einspannring gelegt, darauf gibt man ein Stück dünnes Fließpapier zur Beurteilung der Benetzung und fixiert es mittels Einspannvorrichtung. Die Prüfung erfolgt bei einem Wasserdruck von 0,05 MPa während 2 min. Liegt eine Benetzung vor, so ist die Probe durchgescheuert und hat den Test nicht bestanden.

Tabelle 8:

| | Dicke | Masseverlust** % |
|---|---|---|
| Beispiel 9 extrudiertes und kalandriertes PTFE-Tape | 150 | 1,6 |
| Beispiel 10 extrudiertes und kalandriertes PTFE-Tape + 8,3% $TiO_2$ | 150 | 0,7 |

\*\* Nach 5000 Zyklen wird der Masseverlust durch Wägung bestimmt.

**Patentansprüche**

1. Verfahren zum Herstellen eines Körpers aus gefülltem, mikroporösem gerecktem Polytetrafluorethylen (ePTFE), mit folgenden Schritten:

   a) Mischen einer Menge PTFE mit einem Füllstoff in Form von anorganischen Partikeln mit einer Größe im Bereich von 5 bis 500 nm;

   b) Zugeben eines Gleitmittels zu dem mit Füllstoff gemäß a) gemischten PTFE, und Bilden eines Formkörpers;

   c1) Pastenextrudieren des Formkörpers; und/oder

   c2) Kalandrieren;

   d) Entfernen des Gleitmittels; und

   e) Recken und Sintern des Materials.

2. Verfahren nach Anspruch 1, **gekennzeichnet durch**

   f) anschließend an den Schritt e) Recken des Material in einer zur Reck-Richtung im Schritt e) im wesentlichen senkrechten Richtung.

3. Verfahren nach Anspruch 1 oder 2, **dadurch gekennzeichnet, daß** im Schritt a) eine Trockenmischung durchgeführt wird und dann im Schritt b) dem trockenen Gemisch ein Gleitmittel zudosiert wird.

4. Verfahren nach Anspruch 1 oder 2, **dadurch gekennzeichnet, daß** das Mischen gemäß Schritt a) und die Gleitmittelzugabe gemäß Schritt b) folgende Schritte umfaßt:

   - der Füllstoff wird in dem Gleitmittel dispergiert und
   - die so erhaltene Dispersion wird einem PTFE-Pulver zudosiert.

5. Verfahren nach Anspruch 1, **dadurch gekennzeichnet, daß** das Mischen gemäß Schritt a) folgende Schritte aufweist:

   - der Füllstoff und das PTFE-Material werden jeweils in Wasser dispergiert,

   - die so erhaltene Dispersionen werden gemischt, und

   - das Gemisch wird zum Koagulieren gebracht.

6. Verfahren nach Anspruch 5, umfassend die zusätzlichen Schritte:

   - Abtrennen des Wassers und Trocknen des Materials, und

   - Zudosieren eines Gleitmittels.

7. Verfahren nach einem der Ansprüche 1 bis 6, **dadurch gekennzeichnet, daß** die Füllstoff-Partikel eine Größe von 10 bis 300 nm haben.

8. Verfahren nach einem der Ansprüche 1 bis 7, **dadurch gekennzeichnet, daß** der Füllstoff derart gewählt ist, daß der Körper erhöhte Abriebbeständigkeit erhält.

9. Verfahren nach Anspruch 7 oder 8, **dadurch gekennzeichnet, daß** der Füllstoff aus der Gruppe Oxide und Mischoxide ausgewählt ist.

10. Verfahren nach Anspruch 9, **dadurch gekennzeichnet, daß** die Oberfläche der Oxide und/oder Mischoxide mit langkettigen organischen Verbindungen beladen ist.

**11.** Verfahren nach Anspruch 9 oder 10, **dadurch gekennzeichnet, daß** der Füllstoff $Al_2O_3$ oder $TiO_2$ aufweist oder ein Metall aufweist.

**12.** Verfahren nach einem der Ansprüche 1 bis 7, **dadurch gekennzeichnet, daß** der Füllstoff derart gewählt ist, daß der Körper Hydrophilität erhält.

**13.** Verfahren nach einem der Ansprüche 1 bis 7, **dadurch gekennzeichnet, daß** der Körper UV-undurchlässig wird, indem als Füllstoff insbesondere $TiO_2$ oder ZnO verwendet wird.

**14.** Verfahren nach einem der Ansprüche 1 bis 13, **dadurch gekennzeichnet, daß** der PTFE-Körper eine Membran ist.

**15.** Verfahren nach einem der Ansprüche 1 bis 14, **dadurch gekennzeichnet, daß** der Füllstoff bis zu 50 Gew.-%, bezogen auf die Summe von PTFE und Füllstoff, ausmacht.

**16.** Verfahren nach einem der Ansprüche 1 - 15, bei dem der Füllstoff Nanopartikel aus Kohlenstoff umfaßt.

**17.** PTFE-Körper, insbesondere PTFE-Membran, bestehend aus mikroporösem, gerecktem Polytetrafluorethylen (ePTFE) mit einem anorganischen Füllstoff aus Partikeln mit einer Größe im Bereich von 5 bis 500 nm, welche Bestandteile der ePTFE-Struktur sind, und sich auf den Oberflächen des PTFE-Materials ablagern, ohne die Zwischenräume des Materials auszufüllen.

**18.** PTFE-Körper nach Anspruch 17, **dadurch gekennzeichnet, daß** die Füllstoff-Partikel eine Größe von 10 bis 300 nm haben.

**19.** PTFE-Körper nach Anspruch 17 oder 18, **dadurch gekennzeichnet, daß** der Füllstoff aus der Gruppe Oxide und Mischoxide ausgewählt ist.

**20.** PTFE-Körper nach Anspruch 19, **dadurch gekennzeichnet, daß** die Oberfläche der Oxide und/oder Mischoxide mit langkettigen organischen Verbindungen beladen ist.

**21.** PTFE-Körper nach einem der Ansprüche 17 - 20, **dadurch gekennzeichnet, daß** der Füllstoff $Al_2O_3$ und/oder $TiO_2$ und/oder $ZrO_2$ aufweist oder ein Metall aufweist.

**22.** PTFE-Körper nach einem der Ansprüche 17 - 21, **dadurch gekennzeichnet, daß** er im Vergleich zu einem PTFE-Körper ohne den Füllstoff 3-mal, vorzugsweise 5-mal höhere Abriebfestigkeit aufweist.

**23.** PTFE-Körper nach einem der Ansprüche 17 - 21, **dadurch gekennzeichnet, daß** er hydrophil ist.

**24.** PTFE-Körper nach einem der Ansprüche 17 - 21, **dadurch gekennzeichnet, daß** er im Wellenlängenbereich von 250-380 nm UV-undurchlässig ist und als Füllstoff insbesondere $TiO_2$ oder ZnO enthält.

**25.** PTFE-Körper nach einem der Ansprüche 17 - 24, bei dem der Füllstoff bis zu 50 Gew.-%, bezogen auf die Summe von PTFE und Füllstoff, ausmacht.

**26.** PTFE-Körper nach einem der Ansprüche 17 - 25, bei dem der Füllstoff Nanopartikel aus Kohlenstoff umfaßt.

**Revendications**

**1.** Procédé de préparation d'un corps en polytétrafluoroéthylène étiré (ePTPE), microporeux, comprenant une charge, consistant en les étapes suivantes :

    a) mélanger une quantité de PTFE avec une charge sous la forme de particules inorganiques ayant une taille située dans l'intervalle allant de 5 à 500 nm ;
    b) ajouter un lubrifiant au PTFE mélangé à la charge selon a), et former un corps moule ;
    c1) extruder la pâte du corps moulé, et/ou
    c2) calandrer ;
    d) éliminer le lubrifiant, et

e) étirer et fritter le matériau.

2. Procédé selon la revendication 1, **caractérisé par** l'étape

    f) après l'étape e), étirer le matériau dans une direction essentiellement perpendiculaire à la direction d'étirage de l'étape e).

3. Procédé selon la revendication 1 ou 2, **caractérisé en ce que** dans l'étape a), on réalise un mélange à sec et dans l'étape b), on ajoute le lubrifiant au mélange sec.

4. Procédé selon la revendication 1 ou 2, **caractérisé en ce que** le mélange selon l'étape a) et l'addition du lubrifiant selon l'étape b) comprennent les étapes suivantes :

- la charge est dispersée dans le lubrifiant, et
- la dispersion ainsi obtenue est ajoutée à une poudre de PTFE.

5. Procédé selon la revendication 1, **caractérisé en ce que** le mélange selon l'étape a) présente les étapes suivantes :

- la charge et le matériau PTFE sont chacun dispersé dans de l'eau ;
- les dispersions ainsi obtenues sont mélangées, et
- le mélange est soumis à coagulation.

6. Procédé selon la revendication 5, comprenant les étapes supplémentaires :

- séparation de l'eau et séchage du matériau, et
- addition d'un lubrifiant.

7. Procédé selon l'une des revendications 1 à 6, **caractérisé en ce que** les particules de la charge ont une taille allant de 10 à 300 nm.

8. Procédé selon l'une des revendications 1 à 7, **caractérisé en ce que** la charge est choisie de sorte que le corps obtienne une résistance augmentée à l'usure.

9. Procédé selon la revendication 7 ou 8, **caractérisé en ce que** la charge est choisie parmi le groupe des oxydes et oxydes mixtes.

10. Procédé selon la revendication 9, **caractérisé en ce que** la surface de l'oxyde et/ou de l'oxyde mixtc est chargée de composés organiques à longue chaîne.

11. Procédé selon la revendication 9 ou 10, **caractérisé en ce que** la charge présente de l'$Al_2O_3$ ou du $TiO_2$ ou présente un métal.

12. Procédé selon l'une des revendications 1 à 7, **caractérisé en ce que** la charge est choisie de sorte que le corps obtienne une hydrophilie.

13. Procédé selon l'une des revendications 1 à 7, **caractérisé en ce que** le corps devient imperméable aux U.V., par l'utilisation en particulier de $TiO_2$ ou de ZnO comme charge.

14. Procédé selon l'une des revendications 1 à 13, **caractérisé en ce que** le corps en PTFE est une membrane.

15. Procédé selon l'une des revendications 1 à 14, **caractérisé en ce que** la charge constitue jusqu'à 50% en poids, sur base de la somme du PTFE et de la charge.

16. Procédé selon l'une des revendications 1 à 15, dans lequel la charge comprend des nanoparticules de carbone.

**17.** Corps en PTFE, en particulier membrane en PTFE, consistant en du polytétrafluoroéthylène étiré (ePTFE) microporeux, avec une charge inorganique constituée de particules ayant une taille située dans l'intervalle allant de 5 à 500 nm, qui sont les constituants de la structure en ePTFE et qui sont chargées à la surface du matériau PTFE, sans remplir les espaces vides du matériau et se dépose sur la surface du matériau en PTFE, sans que les espaces libres du matériau soient comblés.

**18.** Corps en PTFE selon la revendication 17, **caractérisé en ce que** les particules de charge ont une taille allant de 10 à 300 nm.

**19.** Corps en PTFE selon la revendication 17 ou 18, **caractérisé en ce que** la charge est choisie parmi le groupe des oxydes et oxydes mixtes.

**20.** Corps en PTFE selon la revendication 19, **caractérisé en ce que** la surface de l'oxyde et/ou de l'oxyde mixte est chargée de composés organiques à longue chaîne.

**21.** Corps en PTFE selon l'une des revendications 17 à 20, **caractérisé en ce que** la charge présente de l'$Al_2O_3$ et/ou du $TiO_2$ et/ou $ZrO_2$ ou présente un métal.

**22.** Corps en PTFE selon l'une des revendications 17 à 21, **caractérisé en ce qu'**il présente par comparaison à un corps en PTFE sans charge, une résistance à l'usure 3 fois, de préférence 5 fois plus élevée.

**23.** Corps en PTFE selon l'une des revendications 17 à 21, **caractérisé en ce qu'**il est hydrophile.

**24.** Corps en PTFE selon l'une des revendications 17 à 21, **caractérisé en ce qu'**il est imperméable aux U.V. dans l'intervalle de longueur d'onde allant de 250 à 380 nm et qu'il contient en particulier du $TiO_3$ ou du ZnO comme charge.

**25.** Corps en PTFE selon l'une des revendications 17 à 24, dans lequel la charge compose jusqu'à 50% en poids, sur base de la somme du PTFE et de la charge.

**26.** Corps en PTFE selon l'une des revendications 17 à 24, dans lequel la charge comprend des nanoparticles de carbone.

**Claims**

**1.** A method for producing a body of filled, microporous expanded polytetrafluoroethylene (ePTFE) comprising the following steps:

a) mixing a quantity of PTFE with a filler in the form of inorganic particles having a size in the range of 5 to 500 nm;
b) adding a lubricant to the PTFE mixed with filler according to a) and producing a formed body;
c1) paste extruding the formed body; and/or
c2) calendering;
d) removing the lubricant, and
e) stretching and sintering the material.

**2.** The method of claim 1, **characterized by**

f) subsequent to step e) stretching the material in a direction substantially perpendicular to the stretching direction in step e).

**3.** The method of claim 1 or 2, **characterized in that** dry mixing is performed in step a) and a lubricant is then charged to the dry mixture in step b).

**4.** The method of claim 1 or 2, **characterized in that** mixing according to step a) and the addition of lubricant according to step b) include the following steps:

- dispersing the filler in the lubricant, and
- charging the thus obtained dispersion to a PTFE powder.

5. The method of claim 1, **characterized in that** mixing according to step a) has the following steps:

- dispersing the filler and the PTFE material in water in each case,
- mixing the thus obtained dispersions, and
- making the mixture coagulate.

6. The method of claim 5, comprising the additional steps:

- separating the water and drying the material, and
- charging a lubricant.

7. The method of any of claims 1 to 6, **characterized in that** the filler particles have a size of 5 to 500 nm, preferably 10 to 300 nm.

8. The method of any of claims 1 to 7, **characterized in that** the filler is selected so as to give the body increased abrasion resistance.

9. The method of claim 7 or 8, **characterized in that** the filler is selected from the group of oxides and mixed oxides.

10. The method of claim 9, **characterized in that** that the surface of the oxides and/or mixed oxides is loaded with long-chain organic compounds.

11. The method of claim 9 or 10, **characterized in that** the filler has $Al_2O_3$ or $TiO_2$ or has a metal.

12. The method of any of claims 1 to 7, **characterized in that** the filler is selected so as to give the body hydrophilicity.

13. The method of any of claims 1 to 7, **characterized in that** the body is made substantially UV-nontransparent by using in particular $TiO_2$ or ZnO as the filler.

14. The method of any of claims 1 to 13, **characterized in that** the PTFE body is a membrane.

15. The method of any of claims 1 to 14, **characterized in that** the filler constitutes up to 50 wt%, based on the sum of PTFE and filler.

16. The PTFE-body of any of claims 1 to 15, wherein the filler comprises nanoparticles made of carbon.

17. A PTFE body, in particular PTFE membrane, consisting of microporous, expanded polytetrafluoroethylene (ePTFE) with an inorganic filler of particles having a size in the range of 5 to 500 nm that are part of the ePTFE structure and deposit on the surfaces of the PTFE material without filling the spaces in the material.

18. The PTFE body of claim 17, **characterized in that** the filler particles have a size of 10 to 300 nm.

19. The PTFE body of claim 17 or 18, **characterized in that** the filler is selected from the group of oxides and mixed oxides.

20. The PTFE body of claim 19, **characterized in that** the surface of the oxides and/or mixed oxides is loaded with long-chain organic compounds.

21. The PTFE body of any of claims 17 to 20, **characterized in that** the filler has $Al_2O_3$ and/or $TiO_2$ and/or $ZrO_2$ or has a metal.

22. The PTFE body of any of claims 17 to 21, **characterized in that** it has an abrasion resistance that is 3 times, preferably 5 times, higher compared to a PTFE body without the filler.

23. The PTFE body of any of claims 17 to 21, **characterized in that** it is hydrophilic.

24. The PTFE body of any of claims 17 to 21, **characterized in that** it is UV-nontransparent in the wave range of 250-380 nm and contains in particular $TiO_2$ or ZnO as the filler.

25. The PTFE body of any of claims 17 to 24, wherein the filler constitutes up to 50 wt%, based on the sum of PTFE and filler.

26. The PTFE body of any of claims 17 to 25, wherein the filler comprises nanoparticles made of carbon.

FIG. 1 A

FIG. 1 B

FIG. 2 A

FIG. 2 B

FIG. 3 A

FIG. 3 B

FIG. 4 A

FIG. 4 B

FIG.5A

FIG.5B

FIG. 6 A

FIG. 6 B

FIG. 7

FIG. 8

FIG. 9